# EUROPEAN PATENT SPECIFICATION

(11) **EP 1 320 894 B1**
(45) Date of publication and mention of the grant of the patent: **22.09.2010**
(21) Application number: 01954938.5
(22) Date of filing: 25.07.2001
(51) Int. Cl.: H01L 33/00

(54) **IMPROVED WINDOW FOR GaN LED**
VERBESSERTES FENSTER FÜR GaN-LED
FENETRE AMELIOREE POUR DIODE PHOTOEMISSIVE (LED) GAN

(30) Priority: 26.07.2000 US 626445
(43) Date of publication of application: 25.06.2003
(73) Proprietor: Lumei Optoelectronics Corporation, El Monte, CA 91731 (US)
(72) Inventor: CHEN, John, Rowland Heights, CA 91748 (US); LIANG, Bingwen, Sunnyvale, CA 94086 (US); SHIH, Robert, Cerritos, CA 90703 (US)
(74) Representative: Meissner, Bolte & Partner
(86) International application number: PCT/US2001/023346
(87) International publication number: WO 2002/009185

(56) References cited:
- EP-A2- 0 622 858
- JP-A- 10 012 921
- US-A- 5 789 768
- US-B1- 6 225 648
- US-B1- 6 287 947

## Description

The present invention relates to an improved window for a gallium nitride (GaN)-based light-emitting diode (LED).

### BACKGROUND OF THE INVENTION

A semiconductor light-emitting diode (LED) includes a substrate, a light emitting region, a window structure, and a pair of electrodes for powering the diode. The substrate may be opaque or transparent. Light-emitting diodes which are based on gallium nitride (GaN) compounds generally include a transparent, insulating substrate, i.e., a sapphire substrate. With a transparent substrate, light may be utilized from either the substrate or from the opposite end of the LED which is termed the "window".

The amount of light generated by an LED is dependent on the distribution of the energizing current across the face of the light emitting region. It is well known in semiconductor technology that the current flowing between the electrodes tends to concentrate in a favored path directly under the electrode. This current flow tends to activate corresponding favored portions of the light emitting region to the exclusion of portions which fall outside the favored path. Further since such favored paths fall under the opaque electrode, the generated light reaching the electrode is lost. Prior art GaN LEDs have employed conductive current spreading layers formed of nickel/gold (Ni/Au), and have a gold (Au) window bond pad mounted on such layers. In such arrangements, the Ni/Au layer and/or the Au bond pad tend to peel during the wire bonding operation to the pad.

JP 10 012921 Document D1 discloses a luminescence semiconductor device, namely a blue-colour.LED device, with improved ejection effectiveness of the light from a luminous layer. The luminescence semiconductor device comprises a sapphire substrate 1, a buffer layer 2 made of GaN, a n-type GaN layer 4, a cathode electrode layer 9, an InGaN layer 5, a p-type GaN layer 3, a translucent NiAu layer 6 made of Ni-Au alloy, a substantially transparent Indium Tin Oxide layer 7 and an anode plate electrode layer 8. The substantially transparent Indium Tin Oxide layer 7 is formed as a single continuous layer with the anode plate electrode layer 8 (as a resistance lowering aluminum bus electrode layer) formed thereon. The buffer layer 2 made of GaN is formed on the sapphire substrate 1, and the n-type GaN layer 4 and the p-type GaN layer 3 are formed on the buffer layer 2 made of GaN. The InGaN layer 5 is sandwiched between the n-type GaN layer 4 and the p-type GaN layer 3. The luminescence semiconductor device comprises the through hole 6a. The through hole 6a extends only through the translucent layer 6, but not through the substantially transparent Indium Tin Oxide (ITO) layer 7, and therefore, the anode plate electrode layer 8 does not pass through the Indium Tin Oxide layer 7 to directly connect to the p-type GaN layer 3.

EP 0 622 858 describes a Gallium Nitride-based III-V Group compound semiconductor device and a method of producing the same. The Gallium Nitride-based III-V Group compound semiconductor device according to the second embodiment of this document comprises a substrate 11, a n-type semiconductor layer 12, a n-electrode 14, a p-type semiconductor layer 13, a p-electrode 15, a cut-off portion 311 and a bonding pad 32 formed of gold. The cut-off portion 311 is provided in the p-electrode 15. The bonding pad 32 formed of gold strongly adheres to the p-type semiconductor layer 13 through the cut-off portion 311 and is electrically connected with the p-electrode 15. The bonding pad 32 not only fills the cut-off portion 311, but also extends over a portion to the p-electrode 15 around the cut-off portion 311.

### SUMMARY OF THE INVENTION

The present invention provides a light emitting diode in accordance with independent claim 1. Further preferred embodiments are given in the dependent claims.

The claimed invention can be better understood in view of the embodiments of the light emitting diode described hereinafter. In general, the described embodiments describe preferred embodiments of the invention. The attentive reader will note, however, that some aspects of the described embodiments extend beyond the scope of the claims. To the respect that the described embodiments indeed extend beyond the scope of the claims, the described embodiments are to be considered supplementary background information and do not constitute definitions of the invention *per se*. This also holds for the subsequent "Brief Description of the Drawings" as well as the "Detailed Description of the Preferred Embodiments."

In particular, the present invention relates to a light emitting diode comprising:
- a substrate;
- a light emitting region;
- a window structure further comprising:
   - a top Mg doped window layer;
   - a thin, semi-transparent metal contact layer of NiOx/Au disposed on said top Mg doped window layer; and
   - a semi-transparent, conductive amorphous current spreading layer formed directly on an exposed face of said contact layer;
- a first electrode having a layer of titanium on a bottom surface thereof, and disposed on said current spreading layer and forming an ohmic connection with said current-spreading layer;
- a second electrode; and
- an opening formed through said contact layer and said current spreading layer, such that said layer of titanium of said first electrode contacts an upper surface of said top Mg doped window layer.

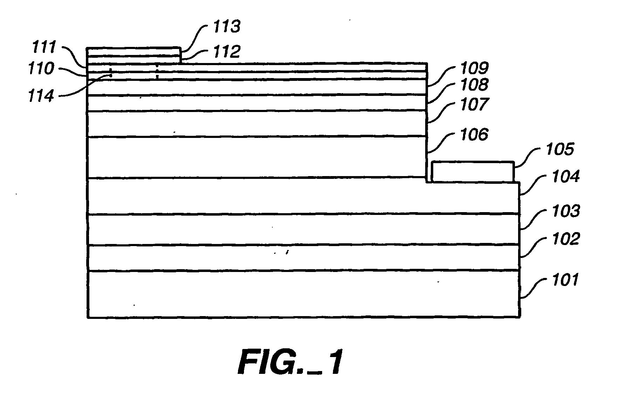

### BRIEF DESCRIPTION OF THE DRAWING

The Figure is a schematic depicting a cross-sectional view of an LED according to one embodiment consistent with the present invention.

### DETAILED DESCRIPTION OF THE PREFERRED EMBODIMENTS

The Figure depicts an LED according to one embodiment consistent with the present invention, as a GaN-based device in which light exits through window 109.

The LED of the Figure includes a sapphire substrate 101, buffer region 102, GaN substitute substrate layer 103, n cladding layer 104, active region 106, p cladding layer 107, window layers 108, 109, n electrode 105, and a window structure which includes a thin NiOₓ/Au semi-transparent layer 110, a semi-transparent amorphous conducting layer 111, a titanium electrode 112, and a bond pad 113.

Layers 101 through 104, and layers 106 through 109, are grown in a Metal Organic Chemical Vapor Deposition (MOCVD) reactor. The details of MOCVD growth of the stated layers are well known in the semiconductor industry and will not be discussed herein.

The remaining components of the illustrative LED, namely layers NiOₓ/Au layer 110, amorphous conducting layer 111, n electrode 105, p electrode 112, and bond pad 113, are formed by evaporation in an apparatus other than a MOCVD reactor. Such processes are well known in the semiconductor industry and are not described herein.

### The light-emitting structure

The illustrative light-emitting structure of the Figure includes an n cladding layer 104, active region 106, and p cladding layer 107.

The n cladding layer 104 is formed of silicon-doped GaN.

In the illustrative example depicted by the Figure, active region 106 is a silicon-doped n-type gallium indium nitride/gallium nitride (GaInN/GaN) multi-quantum well (MQW) structure. However, other forms of active regions may be utilized with the illustrative window structure.

The p cladding layer 107 is formed of Mg -doped aluminium gallium nitride (AlGaN).

### The window layers

The first window layer 108 is formed of Mg-doped GaN. The window layer 108 has a nominal thickness of 300 nm.

The second window layer 109 is similarly formed of Mg-doped GaN. However, window layer 109 is more highly doped to permit an ohmic contact between layer 109 and the very thin NiOₓ/Au layer 110.

### Completion of the MOCVD growth process

Growth of the p-type GaN layers is achieved with the introduction of gaseous flows of TMG with hydrogen (H₂) as a carrier gas, NH₃ as a group V material, and Mg as a dopant. In the absence of an appropriate cool down protocol, hydrogen passivation of the Mg may occur, in which case, the conductivity of the Mg-doped layer is reduced.

In order to avoid hydrogen passivation of the Mg-doped layers 107, 108, and 109, the following described cool-down protocol has been adopted upon completion of the MOCVD growth.
1. The ambient gas of the reactor is switched from H₂ to nitrogen (N₂) immediately after completion of the LED structure;
2. The reactor temperature is ramped down from the growth temperature to about 900 degrees C in about 2 minutes;
3. The flow of NH₃ is terminated;
4. The reactor temperature is further ramped down to about 750 degrees C in about 2 minutes;
5. A temperature of about 750 degrees C is held for about 20 minutes;
6. The heater of the reactor is shut off and the reactor is allowed to complete cool-down naturally. Experience shows that cool-down to 120 degrees C occurs in about 30 minutes after heater shut off.

The resulting product exhibits the expected desired physical and electrical characteristics.

### Formation of the electrode structures

The embodiment consistent with the present invention as depicted by the Figure, illustrates the locations of both p electrode layers 111, 112 and n electrode 105.

Layer 110 is a very thin, semi-transparent contact layer of NiOₓ/Au which is deposited over the entire exposed face of window layer 109. Opening 114 is formed in layers 110 and 111 to permit the deposit of a titanium adhesion layer 112 to contact window layer 109. Titanium forms a strong physical bond with layer 109 and thus tends to eliminate peeling during wire bonding. In addition to reaching through to layer 109, titanium structure 112 is deposited through and on top of amorphous layer 111. Titanium electrode 112 forms ohmic contacts with layers 110 and 111, and forms a Schottky diode contact with window layer 109. The Schottky diode connection to window layer 109 eliminates the current path directly under the electrode and forces current flowing between the electrodes into conducting layer 111.

The p electrode Au bond pad 112 is deposited on top of titanium layer 112 to form an ohmic contact.

Since the Mg-doped layers do not suffer from hydrogen passivation, it is not necessary to heat treat the structure to activate the Mg doping in those layers. However, Ni/Au layer 111 and the Ti and Au contact structures are heated in an atmosphere of molecular nitrogen and air. Thus the Ni is converted to a form of nickel oxide. The described heat treatment improves the quality of the contact structures.

## Claims

1. A light emitting diode comprising:
- a substrate (101);
- a light emitting region (106);
a window structure comprising:
- a top Mg+doped window layer (109);
- a thin, semi-transparent NiOₓ/Au contact layer (110); disposed on said top Mg+ doped window layer (109); and
- a semi-transparent, conductive amorphous current spreading layer (111) formed directly on an exposed face of said contact layer (110);
- a first electrode (112, 113) having a layer of titanium (112) on a bottom surface thereof, and disposed on said current spreading layer and forming an ohmic connection with said current-spreading layer;
- a second electrode (105), **characterised in that**
- an opening (114) is formed through said contact layer and said current spreading layer, such that said layer of titanium of said first electrode contacts an upper surface of said top Mg+doped window layer.

2. The light emitting diode in accordance with claim 1, wherein said amorphous current spreading layer is formed of Indium Tin Oxide.

3. The light emitting diode in accordance with claim 1, wherein said window structure further comprises:
- a bottom Mg-doped window layer disposed under said top Mg+doped window layer;

4. The light emitting diode in accordance with claim 3, wherein said first electrode forms a Schottky diode connection with said top Mg+doped window layer.

5. The light emitting diode in accordance with claim 1, wherein said window structure further comprises:
- a bottom Mg-doped window layer disposed under said top Mg+doped window layer;
- wherein said semi-transparent, conductive amorphous current spreading layer is formed of Indium Tin Oxide; and
- wherein said first electrode forms a Schottky diode connection with said top Mg+doped window layer.

## Patentansprüche

1. Leuchtdiode, mit:
- einem Substrat (101);
- einer Licht emittierenden Zone (106);
einer Fensterstruktur, mit:
- einer oberen Mg⁺-dotierten Fensterschicht (109);
- einer dünnen halb transparenten NiOₓ/Au-Kontaktschicht (110), die auf der oberen Mg⁺-dotierten Fensterschicht (109) angeordnet ist; und
- einer halb transparenten, leitfähigen, amorphen, Strom ausbreitenden Schicht (111), die unmittelbar auf einer frei liegenden Fläche der Kontaktschicht (110) gebildet ist;
- einer ersten Elektrode (112, 113) mit einer Titanschicht (112) auf einer unteren Oberfläche, die auf der Strom ausbreitenden Schicht angeordnet ist und eine Ohm'sche Verbindung mit der Strom ausbreitenden Schicht bildet;
- einer zweiten Elektrode (105),
**dadurch gekennzeichnet, dass**
- eine Öffnung (114) durch die Kontaktschicht und die Strom ausbreitende Schicht so ausgeformt ist, dass die Titanschicht der ersten Elektrode mit einer oberen Oberfläche der oberen Mg⁺-dotierten Fensterschicht in Kontakt steht.

2. Leuchtdiode nach Anspruch 1, bei der die amorphe Strom ausbreitende Schicht aus Indiumzinnoxid besteht.

3. Leuchtdiode nach Anspruch 1, bei der die Fensterstruktur ferner aufweist:
- eine untere Mg⁻-dotierte Fensterschicht, die unter der oberen Mg⁺-dotierten Fensterschicht angeordnet ist.

4. Leuchtdiode nach Anspruch 3, bei der die erste Elektrode eine Schottky-Diodenverbindung mit der oberen Mg⁺-dotierten Fensterschicht bildet.

5. Leuchtdiode nach Anspruch 1, bei der die Fensterstruktur ferner aufweist:
- eine untere Mg⁻-dotierte Fensterschicht, die unter der oberen Mg⁺-dotierten Fensterschicht angeordnet ist,
- wobei die halbtransparente, leitfähige, amorphe Strom ausbreitende Schicht aus Indiumzinnoxid besteht; und
- wobei die erste Elektrode eine Schottky-Diodenverbindung mit der oberen Mg⁺-dotierten Fensterschicht bildet.

## Revendications

1. Diode électroluminescente, comprenant :
- un substrat (101) ;
- une région émettrice de lumière (106) ;
une structure de fenêtre, comprenant :
- une couche-fenêtre supérieure à dopage Mg+ (109) ;
- une couche de contact mince semi transparente NiOₓ/Au (110) disposée sur ladite couche-fenêtre supérieure à dopage Mg+ (109) ; et
- une couche d'étalement de courant amorphe, conductrice et semi-transparente (111) formée directement sur une face exposée de ladite couche de contact (110) ;
- une première électrode (112, 113) ayant une couche de titane (112) sur une surface inférieure d'elle-même et disposée sur ladite couche d'étalement de courant et formant une connexion ohmique avec ladite couche d'étalement de courant ;
- une seconde électrode (105),
**caractérisée en ce que**
- une ouverture (114) est formée à travers ladite couche de contact et ladite couche d'étalement de courant, de telle façon que ladite couche de titane de ladite première électrode vient en contact avec une surface supérieure de ladite couche-fenêtre supérieure à dopage Mg +.

2. Diode électroluminescente selon la revendication 1, dans laquelle ladite couche d'étalement de courant amorphe est formée en oxyde indium-étain.

3. Diode électroluminescente selon la revendication 1, dans laquelle ladite structure-fenêtre comprend en outre :
une couche-fenêtre inférieure à dopage Mg-, disposée au-dessous de ladite couche-fenêtre supérieure à dopage Mg+.

4. Diode électroluminescente selon la revendication 3, dans laquelle ladite première électrode forme une connexion de diode Schottky avec ladite couche-fenêtre supérieure à dopage Mg+.

5. Diode électroluminescente selon la revendication 1, dans laquelle ladite structure-fenêtre comprend en outre :
- une couche-fenêtre inférieure à dopage Mg-, disposée au-dessous de ladite couche-fenêtre supérieure à dopage Mg+ ;
- dans laquelle ladite couche d'étalement de courant amorphe, conductrice et semi transparente, est formée en oxyde indium-étain ; et
- dans laquelle ladite première électrode forme une connexion de diode Schottky avec ladite couche-fenêtre supérieure à dopage Mg+.
